# EUROPEAN PATENT SPECIFICATION

(11) **EP 1 526 111 B1**
(45) Date of publication and mention of the grant of the patent: **09.05.2007**
(21) Application number: 04256256.1
(22) Date of filing: 08.10.2004
(51) Int. Cl.: B82B 1/00, C23C 28/00, F01D 5/28, C23C 14/06, C23C 16/00

(54) **Nano-multilayered structures, components and associated methods of manufacture**
Strukturen aus Vielfachnanoschichten, Bauteile und damit zusammenhängende Herstellungsverfahren
Structures multiples de nanocouches, composants et procédés de manufacture associés

(30) Priority: 10.10.2003 US 684061
(43) Date of publication of application: 27.04.2005
(73) Proprietor: GENERAL ELECTRIC COMPANY, Schenectady, NY 12345 (US)
(72) Inventor: Corderman, Reed Roeder, Niskayuna, New York 12309 (US); Srinivasan, Dheepa, Malleswaram 560003 (IN); Anand, Krishnamurthy, Cooke Town, Bangalore 560005 (IN); Subramanian, Pazhayannur Ramanathan, Niskayuna, New York 12309 (US); Gray, Dennis Michael, Delanson, New York 12053 (US)
(74) Representative: Goode, Ian Roy

(56) References cited:
- WO-A-96/11288
- WO-A-03/078689
- US-A1- 2002 037 220
- TEIXEIRA V ET AL: "Deposition of composite and nanolaminate ceramic coatings by sputtering" VACUUM ELSEVIER UK, vol. 67, no. 3-4, 28 September 2002 (2002-09-28), pages 477-483, XP002319601 ISSN: 0042-207X
- SCANLAN C M ET AL: "TETRAGONAL ZIRCONIA GROWTH BY NANOLAMINATE FORMATION" APPLIED PHYSICS LETTERS, AMERICAN INSTITUTE OF PHYSICS. NEW YORK, US, vol. 64, no. 26, 27 June 1994 (1994-06-27), pages 3548-3550, XP000454609 ISSN: 0003-6951

## Description

The present invention relates generally to nano-multilayered structures, components and associated methods of manufacture. More specifically, the present invention relates to nano-multilayered coating systems for use at elevated temperatures and associated methods for depositing the coating systems on components, such as gas turbine components, aircraft engine components and the like.

In many engineering applications, operating temperatures have increased in order to meet increasingly demanding performance and efficiency requirements. For example, the gas path temperatures in gas turbines, aircraft engines and the like have increased to well over about 1400°C. As a result, the components of these gas turbines, aircraft engines and the like are often exposed to temperatures exceeding about 1000°C. In order to withstand such elevated temperatures, the components are typically made of a high-temperature nickel, cobalt or iron-based superalloy. The components are also protected by an environmental or thermal-insulation coating, referred to as a thermal barrier coating.

Conventional high-temperature coating systems, such as MCrAIY and aluminides, however, have typically been developed for enhanced oxidation resistance, and not enhanced wear resistance, impact resistance, erosion resistance and clearance control. As a result, these coating systems do not retain their hardness and do not display adequate wear resistance, impact resistance, erosion resistance and clearance control at temperatures exceeding about 1000°C. The same is true of conventional thermal-sprayed coating systems, such as tungsten carbides and chromium carbides, and conventional phase-strengthened coating systems, such as Triballoy 800. Likewise, conventional ceramic thermal barrier coatings do not have the required toughness and do not display adequate wear resistance, impact resistance, erosion resistance and clearance control at temperatures exceeding about 1000°C.

Thus, what is needed is a coating system that provides enhanced wear resistance, impact resistance, erosion resistance and clearance control at temperatures exceeding about 1000°C. At such elevated temperatures, the coating system must retain its hardness, toughness and oxidation resistance. Finally, the coating system must be capable of being deposited on a component, such as a gas turbine component, an aircraft engine component or the like, using conventional deposition methods.

In various embodiments, the high-temperature nano-multilayered structures, components and associated methods of manufacture of the present invention utilize a plurality of alternating metallic alloy and ceramic oxide layers. These metallic alloy and ceramic oxide layers are selected such that they display adequate intrinsic oxidation resistance, especially above about 1000°C, and adhere to one another. The thickness of each of the metallic alloy and ceramic oxide layers is on a nano scale, resulting in a nano-multilayered coating system with a thickness that is on a micron scale. The number of metallic alloy and ceramic oxide layers utilized may vary, depending upon the thickness of each of the metallic alloy and ceramic oxide layers and the desired thickness of the nano-multilayered coating system. The thickness of the metallic alloy and ceramic oxide layers may be independently adjusted to control the hardness, strain tolerance and overall stability of the nano-multilayered coating system when subjected to thermo-mechanical stresses.

In one embodiment of the present invention, a nano-multilayered structure suitable for use in high-temperature applications includes a plurality of metallic alloy layers, wherein the thickness of each of the plurality of metallic alloy layers is on a nano scale, and a plurality of ceramic oxide layers disposed between the plurality of metallic alloy layers in an alternating manner, wherein the thickness of each of the plurality of ceramic oxide layers is on a nano scale.

In another embodiment of the present invention, a high-temperature component includes a substrate having a surface and a nano-multilayered structure disposed on the surface of the substrate. The nano-multilayered structure includes a plurality of metallic alloy layers, wherein the thickness of each of the plurality of metallic alloy layers is on a nano scale, and a plurality of ceramic oxide layers disposed between the plurality of metallic alloy layers in an alternating manner, wherein the thickness of each of the plurality of ceramic oxide layers is on a nano scale.

In a further embodiment of the present invention, a method for manufacturing a nano-multilayered structure suitable for use in high-temperature applications includes providing a substrate having a surface. The method also includes disposing a plurality of metallic alloy layers adjacent to the surface of the substrate, wherein the thickness of each of the plurality of metallic alloy layers is on a nano scale. The method further includes disposing a plurality of ceramic oxide layers adjacent to the surface of the substrate and between the plurality of metallic alloy layers in an alternating manner, wherein the thickness of each of the plurality of ceramic oxide layers is on a nano scale.

Embodiments of the invention will now be described, by way of example, with reference to the accompanying drawings, in which:
Figure 1 is a cross-sectional side view of one embodiment of a high-temperature nano-multilayered structure of the present invention, including a plurality of metallic alloy and ceramic oxide layers disposed on the surface of a substrate; and
Figure 2 is a flow chart of one embodiment of a method for manufacturing the high-temperature nano-multilayered structure of Figure 1.

The high-temperature nano-multilayered structures, components and associated methods of manufacture of the present invention are based on the premise that a layered structure displays higher hardness and better wear resistance, impact resistance, erosion resistance and clearance control than would otherwise be predicted by the rule of mixtures. This is true because, when alternating layers of materials with different elastic moduli and crystal structures are brought together, the resistance to dislocation of the structure as a whole increases. This results from the plastic constraint experienced by dislocations when they are forced to travel in relatively narrow channels, image forces transmitted from one layer to another and the elastic modulus mismatch between adjacent layers. In other words, plastic flow in relatively ductile layers is constrained by more brittle layers and dislocation motion is restricted by pile-up mechanisms, image forces and elastic modulus mismatch effects. Cracks initiated within the more brittle layers are blunted by the relatively ductile layers and, under indentation conditions where the directions of principal tensile stresses change in orientation, cracks cannot travel along a fixed path as they are continuously deflected at layer boundaries.

Nano-multilayered coating systems have been developed for use in such applications as cutting tools and the like. The nano-multilayered coating systems typically include a plurality of nitride layers of alternating compositions, such as Ti-TiN, TiN-TiAIN, TiN-NbN, TiN-TaN or TiN-VN. The nitride layers each have a thickness of between about 0.1 nm and about 30 nm and are applied to a total thickness of about 0.5 µm to about 20 µm on a relatively hard substrate, such as hardened tool steel, cemented tungsten carbide cobalt or the like. Likewise, the nano-multilayered coating systems may include a plurality of metal nitrides, metal carbides and alumina (such as gamma alumina) and/or carbonitrides, forming a plurality of aperiodic layers, without regular spacing, or a structure with a continuously varying composition. The metal may include Ti, Nb, Hf, V, Ta, Mo, Zr, Cr, W, Al or a mixture thereof. The nitride-based nano-multilayered coating systems and the like, however, are unsuitable for use at temperatures above about 600°C because they tend to oxidize. At their relatively low thicknesses, the nitride-based nano-multilayered coating systems and the like are also unsuitable for use with relatively soft substrates, such as copper, aluminum, copper alloys, aluminum alloys and the like, as the stress fields associated with contacting asperities may plastically deform the base material and cause the coating material to peel off.

In various embodiments, the high-temperature nano-multilayered structures, components and associated methods of manufacture of the present invention utilize a plurality of alternating metallic alloy and ceramic oxide layers. These metallic alloy and ceramic oxide layers are selected such that they display adequate intrinsic oxidation resistance, especially above about 1000°C, and adhere to one another. Preferably, the thickness of each of the metallic alloy and ceramic oxide layers is between about 3 nm and about 200 nm, resulting in a nano-multilayered coating system with a thickness of between about 3 µm and about 200 µm. The number of metallic alloy and ceramic oxide layers utilized may vary, depending upon the thickness of each of the metallic alloy and ceramic oxide layers and the desired thickness of the nano-multilayered coating system. The thickness of the metallic alloy and ceramic oxide layers may be independently adjusted to control the hardness, strain tolerance and overall stability of the nano-multilayered coating system when subjected to thermo-mechanical stresses.

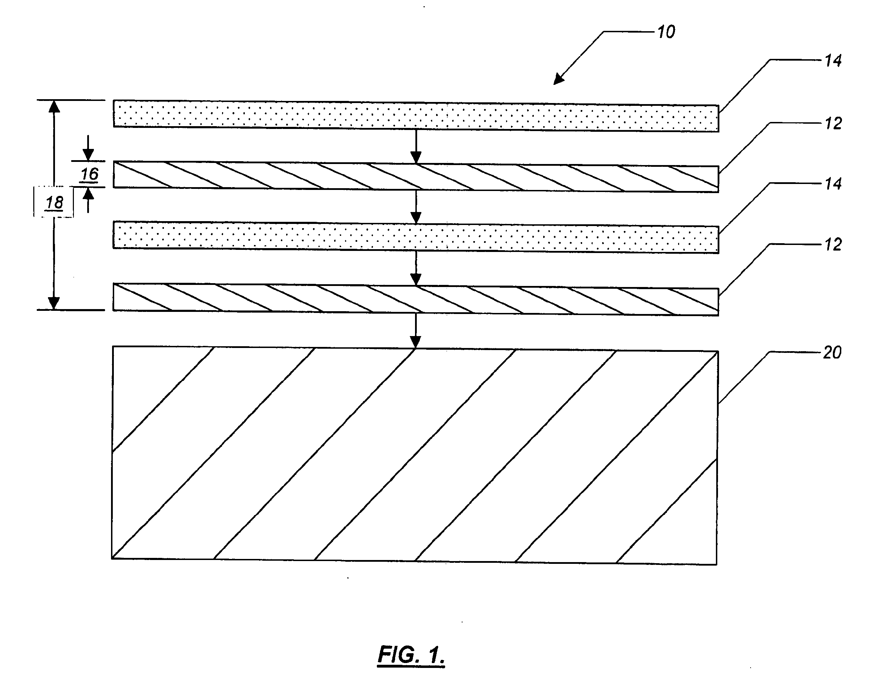

Referring to Figure 1, in one embodiment of the present invention, the nano-multilayered structure consists of a nano-multilayered coating system 10 including a plurality of metallic alloy layers 12 disposed between a plurality of ceramic oxide layers 14 in an alternating manner. Preferably, the thickness 16 of each of the metallic alloy layers 12 and ceramic oxide layers 14 is between about 3 nm and about 200 nm, more preferably between about 10 nm and about 100 nm, resulting in a nano-multilayered coating system 10 with a thickness 18 of between about 3 µm and about 200 µm, more preferably of between about 5 µm and about 150 µm. The number of metallic alloy layers 12 and ceramic oxide layers 14 utilized may vary, depending upon the thickness 16 of each of the metallic alloy layers 12 and ceramic oxide layers 14 and the desired thickness 18 of the nano-multilayered coating system 10.

The plurality of metallic alloy layers 12 may each be made of, for example, nickel aluminide (NiAl), nickel aluminide doped with Hf (NiAl (Hf)), nickel aluminide doped with Zr (NiAl (Zr)), platinum aluminide (PtAl) or MCrAlY, where M is at least one of nickel, iron, cobalt and a combination thereof. The plurality of ceramic oxide layers 14 may each be made of, for example, alumina, yttria, zirconia, yttria-stabilized zirconia (YSZ), hafnia, a yttrium-based garnet, mullite or the like. Other suitable materials may, however, be used.

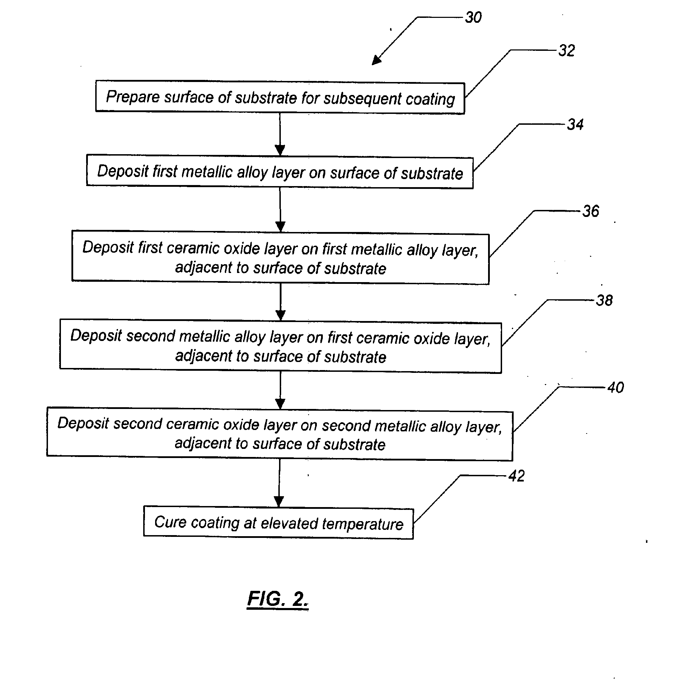

Referring to Figure 2, in another embodiment of the present invention, a method 30 for manufacturing the nano-multilayered coating system 10 (Figure 1) of the present invention includes preparing the surface of a substrate 20 (Figure 1) for subsequent coating. (Block 32). For example, the surface of the substrate 20 may be prepared by grit blasting, polishing, chemical cleaning, ultrasonic washing, degreasing or a combination thereof. As described above, the substrate may include a high-temperature nickel, cobalt or iron-based superalloy or the like, such as that used to form a component of a gas turbine, an aircraft engine or the like. After the surface of the substrate 20 is prepared for subsequent coating, a first metallic alloy layer 12 (Figure 1) is deposited on the surface of the substrate 20 using a physical or chemical vapor deposition method, such as, for example, chemical vapor deposition (CVD), plasma-enhanced chemical vapor deposition (PECVD), electron beam-physical vapor deposition, cathodic arc coating, sputtering, ion plasma coating or the like, well known to those of ordinary skill in the art. (Block 34). Alternatively, thermal spraying techniques, such as flame spraying, plasma spraying, high velocity oxygen fuel spraying and the like, also well known to those of ordinary skill in the art, may be used to deposit the first metallic alloy layer 12, as well as subsequent alloy layers. A first ceramic oxide layer 14 (Figure 1) is then deposited on the first metallic alloy layer 12, adjacent to the surface of the substrate 20. (Block 36). A second metallic alloy layer 12 is then deposited on the first ceramic oxide layer 14, adjacent to the surface of the substrate 20, (Block 38), and a second ceramic oxide layer 14 is deposited on the second metallic alloy layer 12, adjacent to the surface of the substrate 20, (Block 40), and so on. Alternatively, a ceramic oxide layer 14 may be deposited on the surface of the substrate 20 prior to the deposition of any metallic alloy layer 12. In one embodiment, the first ceramic oxide layer 14, as well as subsequent ceramic oxide layers, is deposited using a physical or chemical vapor deposition method, such as, for example, chemical vapor deposition (CVD), plasma-enhanced chemical vapor deposition (PECVD), electron beam-physical vapor deposition, cathodic arc coating, sputtering, ion plasma coating or the like, well known to those of ordinary skill in the art. In another embodiment, thermal spraying techniques, such as flame spraying, plasma spraying, high velocity oxygen fuel spraying and the like, also well known to those of ordinary skill in the art, may be used to deposit the first ceramic oxide layer 14, as well as subsequent ceramic oxide layers. Finally, the nano-multilayered coating system 10 may be heat treated at an elevated temperature in a range of between about 600°C and about 1400°C, or up to about 80% of the melting temperature of the nano-multilayered coating system 10. (Block 42). In one embodiment, the nano-multilayered coating system 10 is heat treated at a temperature of between about 600°C and about 900°C.

The following example is included to provide additional guidance to those of ordinary skill in the art in practicing the invention, and is merely representative of the work that contributes to the teaching of the present invention. Accordingly, the example is not intended to limit the invention, as defined in the appended claims, in any manner.

For example, the two layered nanocomposites Cu-Mo and Ni20Cr-ZrO₂(7Y₂O₃) (also known in the art as yttria-stabilized zirconia, ZrO₂(7Y₂O₃), or 7YSZ) were produced by sputtering. A side sputtering system capable of depositing both conducting and insulating thin films, using either DC or RF potential, was used to produce both nano-multilayered thin film materials. In addition, the sputtering system may be used to clean the substrate *in vacuo* before thin film deposition.

In a typical experiment, glass slides, silica slides, silicon wafers and Cr-plated steel substrates are mounted onto a carrier plate, or pallet, mounted vertically inside the vacuum chamber of the sputtering system. The pallet can travel in a computer controlled sequence to either the vacuum load lock, the NiCr sputter target, the 7YSZ sputter target or the sputter etch area. The pallet with mounted substrates is first loaded into the vacuum chamber through the vacuum load lock and is immediately sent to the sputter etch area, where the stationary substrates are cleaned by Ar+ ion bombardment for 30 seconds at 0.8 kV potential and 1.3 Pa (10 mTorr) Ar pressure. Second, the pallet then traverses the NiCr sputter target area at 50 cm/min, 2 kV potential and 1.6 Pa (12 mTorr) Ar pressure to deposit 50 nm NiCr on the substrates. Third, the pallet traverses the 7YSZ sputter target area at 5 cm/min, 0.52 kW power and 2 Pa (15 mTorr) Ar pressure to deposit 50 nm YSZ. The second and third steps then repeat 49 additional times to produce a nano-multilayered thin film with 50 layers of 50 nm Ni20Cr and 50 layers of 50 nm 7YSZ, for a total thickness of 5 micrometers. A similar procedure may be used to produce multilayered thin films with virtually any range of layer thicknesses, from about 1 nm to about 1000 nm, limited only by the time required to complete the individual and multiple sputtering steps.

## Claims

1. A nano-multilayered structure (10) suitable for use in high-temperature applications, comprising:
a plurality of metallic alloy layers (12), wherein the thickness (16) of each of the plurality of metallic alloy layers (12) is on a nano scale; and
a plurality of ceramic oxide layers (14) disposed between the plurality of metallic alloy layers (12) in an alternating manner, wherein the thickness (16) of each of the plurality of ceramic oxide layers (14) is on a nano scale.

2. The structure (10) of claim 1, wherein each of the plurality of metallic alloy layers (12) comprises a material selected from the group consisting of nickel aluminide, nickel aluminide doped with Hf, nickel aluminide doped with Zr, platinum aluminide and an MCrAIY alloy, wherein M comprises at least one of nickel, cobalt, iron and a combination thereof.

3. The structure (10) of claim 1, wherein each of the plurality of ceramic oxide layers (14) comprises at least one material selected from the group consisting of alumina, yttria, zirconia, yttria-stabilized zirconia, hafnia, a yttrium-based garnet and mullite.

4. The structure (10) of claim 1, wherein the thickness (16) of each of the plurality of metallic alloy layers (12) and each of the plurality of ceramic oxide layers (14) is between about 3 nm and about 200 nm.

5. The structure (10) of claim 4, wherein the thickness (16) of each of the plurality of metallic alloy layers (12) and each of the plurality of ceramic oxide layers (14) is between about 10 nm and about 100 nm.

6. The structure (10) of claim 1, wherein the collective thickness (18) of the plurality of metallic alloy layers (12) and the plurality of ceramic oxide layers (14) is between about 3 µm and about 200 µm.

7. The structure (10) of claim 6, wherein the collective thickness (18) of the plurality of metallic alloy layers (12) and the plurality of ceramic oxide layers (14) is between about 5 µm and about 150 µm

8. The structure (10) of claim 1, wherein the nano-multilayered structure (10) comprises a nano-multilayered coating system (10).

9. The structure (10) of claim 1, further comprising a substrate (20) having a surface, wherein the plurality of metallic alloy layers (12) and the plurality of ceramic oxide layers (14) are disposed on the surface of the substrate (20).

10. The structure (10) of claim 9, wherein the substrate (20) comprises at least one of a nickel-based superalloy, a cobalt-based superalloy, an iron-based superalloy, and an MCrAlY alloy, wherein M comprises at least one of nickel, cobalt, iron and a combination thereof.

## Patentansprüche

1. Vielschichtige Nanostruktur (10) geeignet zum Gebrauch bei Hochtemperatur-Anwendungen, umfassend:
eine Mehrzahl metallischer Legierungsschichten (12), wobei die Dicke (16) jeder der Mehrzahl metallischer Legierungsschichten (12) in einem Nanomassstab liegt und
eine Mehrzahl von keramischen Oxidschichten (14), die zwischen der Mehrzahl metallischer Legierungsschichten (12) in einer alternierenden Weise angeordnet ist, worin die Dicke (16) jeder der Mehrzahl von keramischen Oxidschichten (14) in einem Nanomassstab liegt.

2. Struktur (10) nach Anspruch 1, worin jede der Mehrzahl metallischer Legierungsschichten (12) ein Material umfasst, das ausgewählt ist aus der Gruppe, bestehend aus Nickelaluminid, mit Hf dotiertem Nickelaluminid, mit Zr dotiertem Nickelaluminid, Platinaluminid und einer MCrAlY-Legierung, worin M mindestens eines von Nickel, Cobalt, Eisen und eine Kombination davon umfasst.

3. Struktur (10) nach Anspruch 1, worin jede der Mehrzahl keramischer Oxidschichten (14) mindestens ein Material umfasst, das ausgewählt ist aus der Gruppe bestehend aus Aluminiumoxid, Yttriumoxid, Zirkoniumdioxid, Yttriumoxidstabilisiertem Zirkoniumdioxid, Hafniumdioxid, einem Granat auf Yttriumbasis und Mullit.

4. Struktur (10) nach Anspruch 1, worin die Dicke (16) jeder der Mehrzahl metallischer Legierungsschichten (12) und jeder der Mehrzahl keramischer Oxidschichten (14) zwischen etwa 3 nm und etwa 200 nm beträgt.

5. Struktur (10) nach Anspruch 4, worin die Dicke (16) jeder der Mehrzahl metallischer Legierungsschichten (12) und jeder der Mehrzahl keramischer Oxidschichten (14) zwischen etwa 10 nm und etwa 100 nm beträgt.

6. Struktur (10) nach Anspruch 1, worin die kollektive Dicke (18) der Mehrzahl metallischer Legierungsschichten (12) und der Mehrzahl keramischer Oxidschichten (14) zwischen etwa 3 µm und etwa 200 µm beträgt.

7. Struktur (10) nach Anspruch 6, worin die kollektive Dicke (18) der Mehrzahl metallischer Legierungsschichten (12) und der Mehrzahl keramischer Oxidschichten (14) zwischen etwa 5 µm und etwa 150 µm beträgt.

8. Struktur (10) nach Anspruch 1, worin die vielschichtige Nanostruktur (10) ein vielschichtiges Nano-Überzugssystem (10) umfasst.

9. Struktur (10) nach Anspruch 1, weiter umfassend ein Substrat (20), das eine Oberfläche aufweist, wobei die Mehrzahl metallischer Legierungsschichten (12) und die Mehrzahl keramischer Oxidschichten (14) auf der Oberfläche des Substrates angeordnet ist.

10. Struktur (10) nach Anspruch 9, worin das Substrat mindestens eines von einer Superlegierung auf Nickelbasis, einer Superlegierung auf Cobaltbasis, einer Superlegierung auf Eisenbasis und einer MCrAlY-Legierung umfasst, worin M mindestens eines von Nickel, Cobalt, Eisen und eine Kombination davon umfasst.

## Revendications

1. Nanostructure multicouche (10) appropriée pour une utilisation dans des applications à haute température, comprenant :
une pluralité de couches (12) d'alliage métallique, dans laquelle l'épaisseur (16) de chacune de la pluralité de couches (12) d'alliage métallique se situe sur une échelle nanométrique ; et
une pluralité de couches (14) d'oxyde de céramique disposée entre la pluralité de couches (12) d'alliage métallique d'une façon alternée, dans laquelle l'épaisseur (16) de chacune de la pluralité de couches (14) d'oxyde de céramique se situe sur une échelle nanométrique.

2. Structure (10) selon la revendication 1, dans laquelle chacune de la pluralité de couches (12) d'alliage métallique comprend un matériau sélectionné dans le groupe composé de l'aluminide de nickel, de l'aluminide de nickel dopé avec de l'hafnium, de l'aluminide de nickel dopé avec du zirconium, de l'aluminide de platine et d'un alliage de MCrAlY, dans lequel M comprend au moins un parmi le nickel, le cobalt, le fer et une combinaison de ceux-ci.

3. Structure (10) selon la revendication 1, dans laquelle chacune de la pluralité de couches (14) d'oxyde de céramique comprend au moins un matériau sélectionné dans le groupe composé de l'alumine, de l'oxyde d'yttrium, de la zircone, de la zircone stabilisée à l'oxyde d'yttrium, de l'hafnium, d'un grenat et d'une mullite à base d'oxyde d'yttrium.

4. Structure (10) selon la revendication 1, dans laquelle l'épaisseur (16) de chacune de la pluralité de couches (12) d'alliage métallique et de chacune de la pluralité de couches (14) d'oxyde de céramique se situe entre environ 3 nm et environ 200 nm.

5. Structure (10) selon la revendication 4, dans laquelle l'épaisseur (16) de chacune de la pluralité de couches (12) d'alliage métallique et de chacune de la pluralité des couches (14) d'oxyde de céramique se situe entre environ 10 nm et environ 100 nm.

6. Structure (10) selon la revendication 1, dans laquelle l'épaisseur collective (18) de la pluralité de couches (12) d'alliage métallique et de la pluralité de couches (14) d'oxyde de céramique se situe entre environ 3 µm et environ 200 µm.

7. Structure (10) selon la revendication 6, dans laquelle l'épaisseur collective (18) de la pluralité de couches (12) d'alliage métallique et de la pluralité de couches (14) d'oxyde de céramique se situe entre environ 5 µm et environ 150 µm.

8. Structure (10) selon la revendication 1, dans laquelle la nanostructure multicouche (10) comprend un nanosystème multicouche (10) de revêtement.

9. Structure (10) selon la revendication 1, comprenant en outre un substrat (20) ayant une surface, dans laquelle la pluralité de couches (12) d'alliage métallique et la pluralité de couches (14) d'oxyde de céramique sont disposées sur la surface du substrat (20).

10. Structure (10) selon la revendication 9, dans laquelle le substrat (20) comprend au moins un parmi un superalliage à base de nickel, un superalliage à base de cobalt, un superalliage à base de fer, et un alliage de MCrAIY, dans lequel M comprend au moins un parmi le nickel, le cobalt, le fer et une combinaison de ceux-ci.
